# EUROPÄISCHE PATENTSCHRIFT

(11) **EP 0 653 906 B1**
(45) Veröffentlichungstag und Bekanntmachung des Hinweises auf die Patenterteilung: **04.09.1996**
(21) Anmeldenummer: 94116927.8
(22) Anmeldetag: 26.10.1994
(51) Int. Cl.: H05K 7/14

(54) **Einrichtung für eine Elektronikbox zur Aufnahme weiterer elektronischer Baugruppen**
Device for cabinet for extended electronic components assemblies
Dispositif pour boîte électronique pour assemblages étendue de components électronique

(30) Priorität: 12.11.1993 DE 4338753
(43) Veröffentlichungstag der Anmeldung: 17.05.1995
(73) Patentinhaber: SIEMENS AKTIENGESELLSCHAFT, 80333 München (DE)
(72) Erfinder: Hecht, Franz, Dipl.-Ing. (FH), D-91074 Herzogenaurach (DE); Kurze, Bernd, Dipl.-Ing., D-91056 Erlangen (DE)

(56) Entgegenhaltungen:
- WO-A-90/03720
- US-A- 4 038 696

## Beschreibung

### Einrichtung für eine Elektronikbox zur Aufnahme weiterer elektronischer Baugruppen

Die Erfindung bezieht sich auf eine Einrichtung für eine mit wenigstens einer elektronischen Baugruppe versehenen Elektronikbox zur Aufnahme weiterer elektronischer Baugruppen, die jeweils mit der bereits vorhandenen Baugruppe elektrisch leitend verbindbar sind.

Elektronische Baugruppen, auch Flachbaugruppen genannt, der Informationselektronik werden meist durch hochpolige Steckverbinder miteinander verbunden. Bei Stromrichtergeräten werden beispielsweise einige Flachbaugruppen als sogenannte Optionsbaugruppen (Technologiebaugruppe, Schnittstellenbaugruppe) erst nachträglich in ein solches Gerät gesteckt bzw. mit ausgerüstet. Dabei müssen diese Optionsbaugruppen aber jeweils mit der bereits vorhandenen Baugruppe (Standardbaugruppe) elektrisch leitend verbunden werden. Eine Kommunikation der Optionsbaugruppen untereinander bzw. der Optionsbaugruppen mit der Standardbaugruppe erfolgt mittels eines Gerätebusses, auch Systembus genannt.

Im Handel sind Stromrichtergeräte erhältlich, die das Problem des Nachrüstens mit Optionsbaugruppen auf verschiedenen Wegen gelöst haben.

Aus dem Siemens-Prospekt "3∼SIMOREG-K-Geräte in Hybridtechnik - Drehzahlveränderbare Gleichstromantriebe" ist ein Kompaktstromrichtergerät bekannt, das schon in der Grundausführung mit einer Reihe von Zusatz- und Hilfsfunktionen ausgestattet ist. Diese Funktionen sind über mehrere Flachbaugruppen verteilt, die im Gehäuse übereinander angeordnet sind. Dabei ist jede Baugruppe mit Laschen des Gehäuses lösbar verbunden. Die Kommunikation dieser Baugruppen untereinander erüber Flachbandkabel-Busverbindungen. Eine derartige Ausgestaltung der Flachbaugruppen der Informationselektronik ist service- und bedienungsunfreundlich, da der Montageaufwand erheblich ist.

Aus dem Siemens-Prospekt "SIMOVERT P Spannungszwischenkreis-Umrichter 6SE12 für Antriebe bis 37 kW" ist ein Einbaugerät bzw. ein Komplettgerät eines Spannungszwischenkreis-Umrichters bekannt, bei dem unmittelbar hinter der Gerätetür ein schwenkbarer Baugruppenträger zur Aufnahme der Reglungsbaugruppe und der Optionsbaugruppen (Technologiebaugruppe, Schnittstellenbaugruppe) angeordnet ist. Dieser Baugruppenträger, auch Elektronikbox genannt, ist in dem deutschen Gebrauchsmuster G 8 812 275 ausführlich beschrieben. Gegenüber dem vorgenannten Stromrichtergerät sind hier die Optionsbaugruppen leicht zugänglich und können schnell ausgetauscht werden, da sie in diese Elektronikbox geführt sind. Die Kommunikation der Baugruppen dieser Elektronikbox untereinander erfolgt ebenfalls mit Flachbandkabel-Busverbindungen. Der Nachteil dieser Ausgestaltung der Elektronikbox besteht darin, daß bei der Erstellung der Elektronikbox bereits feststehen muß, wieviele Baugruppen in diese Elektronikbox maximal hineinpassen müssen.

Bei einem weiteren Spannungszwischenkreis-Umrichter, bekannt aus dem Siemens-Katalog DA 66.2-1992 mit dem Titel "Spannungszwischenkreis-Umrichter SIMOVERT P für drehzahlveränderbare Drehstromantriebe", ist ein Baugruppenträger (Einbausystem ES 902) vorgesehen. Dieser Baugruppenträger ist in der Standardausführung bestückt mit den Baugruppen "Elektronik-Stromversorgung RPS (Rack Power Supply)" und "Steuer- und Regelbaugruppe ICS (Inverter Control System)". Bei einer Standarderweiterung Netzrückspeisung über einen gegenparallelen vollgesteuerten Netzstromrichter wird der Baugruppenträger zusätzlich mit der Baugruppe "Netzsteuersatz und Zwischenkreisregelung DLC (DC-Link Controller)" bestückt.

Bei Parallelschaltumrichtern erweitert sich der Baugruppenträger um die Baugruppe "Impulsverteiler- und Störauswertebaugruppe IPD (Inverter Pulse Distributer)". Außerdem weist dieser Baugruppenträger noch weitere vier freie Steckplätze auf. Die Baugruppen werden über eine Busleiterplatte, auch Rückplatte (back plane) genannt, auf der Rückseite des Baugruppenträgers elektrisch untereinander verbunden. Diese Ausgestaltung des Baugruppenträgers, der bereits im Grundgerät die Busverbindung der Optionsbaugruppen aufweist, ist einfach zu bedienen, jedoch eine kostenintensive Lösung.

Der Erfindung liegt nun die Aufgabe zugrunde, eine sehr kostengünstige Möglichkeit anzugeben, mit der eine Elektronikbox mit elektronischen Baugruppen nachträglich aufgerüstet werden kann.

Diese Aufgabe wird erfindungsgemäß dadurch gelöst, daß eine Einrichtung zur Aufnahme weiterer elektronischer Baugruppen, die jeweils mit einer bereits vorhandenen Baugruppe elektrisch leitend verbindbar sind, vorgesehen ist, die ein mehrteiliges Aufnahmeteil aufweist, das aus einer Montageplatte mit stirnseitig schwenkbar angebrachten, zur Führung der weiteren Baugruppen vorgesehenen Platten besteht, wobei die Montageplatte auf der von den Baugruppen zugewandten und abgewandten Seite jeweils Verriegelungshaken aufweist, mit denen einerseits eine mit Federleisten versehene Rückplatte mit der Montageplatte und andererseits diese Einrichtung mit der Elektronikbox lösbar verbunden sind.

Mit dieser erfindungsgemäßen Einrichtung erhält man eine besonders kostengünstige Möglichkeit, eine Elektronikbox nachträglich mit weiteren elektronischen Baugruppen aufzurüsten, wobei diese weiteren Baugruppen elektrisch leitend mit dem Bussystem der bereits vorhandenen Baugruppe der Elektronikbox verbindbar ist. Bei dieser Aufrüstung der Elektronikbox, die selbst ein Einfachgehäuse sein kann, muß diese nicht zerlegt bzw. ausgebaut werden. Außerdem bleibt die Tauschbarkeit der Baugruppen erhalten und der Raum für Frontplatten-Einbauelemente an der Frontseite jeder Baugruppe wird ebenfalls nicht reduziert. Ferner kann die erfindungsgemäße Einrichtung auf einfache und kostengünstige Art und Weise in eine Elektronikbox gesteckt werden, ohne dabei Werkzeug zu benutzen. Bei der Montage der Einrichtung in eine Elektronikbox werden keine zusätzlichen Verbindungselemente benötigt. Der Einsatz dieser Einrichtung ist in jedem Gehäuse bzw. jeder Elektronikbox möglich, sofern Durchbrüche und Aufnahmen für die Verriegelung und Fixierung der Einrichtung vorgesehen sind.

Die vorteilhaften Ausführungsformen der Einrichtung zur Aufnahme weiterer elektronischer Baugruppen sind den Unteransprüchen 2 bis 10 zu entnehmen.

Zur weiteren Erläuterung wird auf die Zeichnung Bezug genommen, in der eine Ausführungsform der erfindungsgemäßen Einrichtung schematisch veranschaulicht ist.
- Figur 1: zeigt die Frontansicht eines mehrteiligen Aufnahmeteils der erfindungsgemäßen Einrichtung im Anlieferungszustand, in
- Figur 2: ist die Rückansicht dieses mehrteiligen Aufnahmeteils nach Figur 1 dargestellt, die
- Figur 3: zeigt die erfindungsgemäße Einrichtung im Einbauzustand, wogegen in
- Figur 4: die Einrichtung in einer Elektronikbox gezeigt wird, und die
- Figur 5: stellt den Ablauf für eine Nachrüstung einer Elektronikbox mit der erfindungsgemäßen Einrichtung dar.

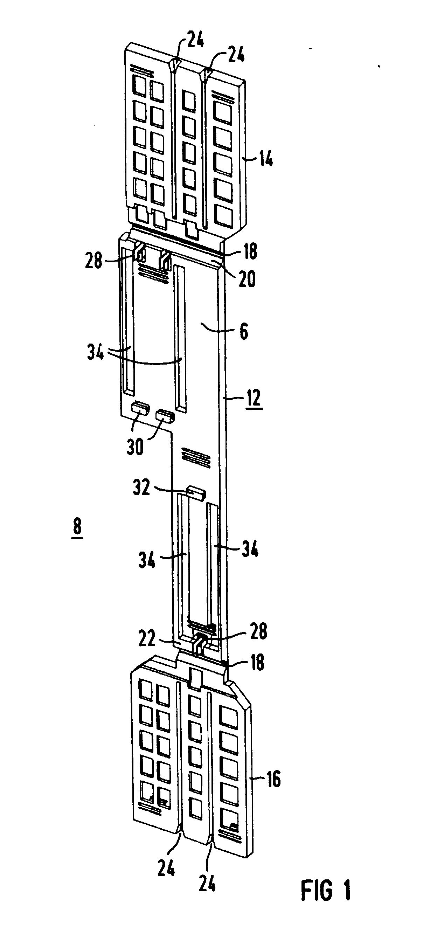

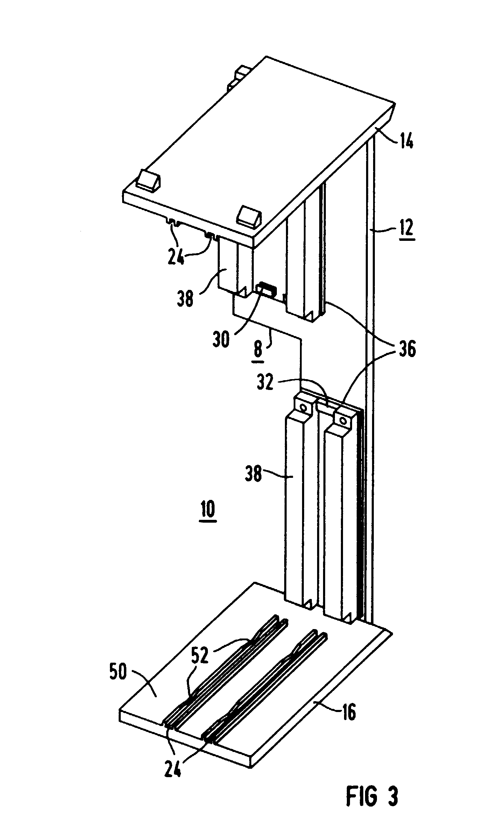

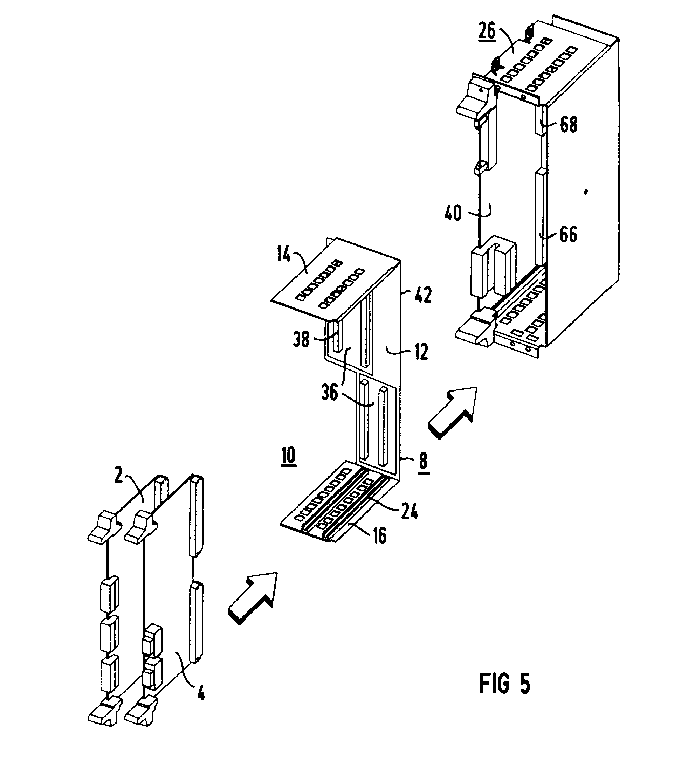

Die Figur 1 zeigt die Frontansicht, d.h. die den weiteren Baugruppen 2 und 4 zugewandte Seite 6 eines mehrteiligen Aufnahmeteils 8 einer erfindungsgemäßen Einrichtung 10, die im Einbauzustand in der Figur 3 dargestellt ist. Dieses mehrteilige Aufnahmeteil 8 besteht aus einer Montageplatte 12 und schwenkbaren Platten 14 und 16. Diese schwenkbaren Platten 14 und 16 sind jeweils mittels eines Filmscharniers 18 mit einer Stirnseite 20, 22 der Montageplatte 12 verbunden. Die Filmscharniere 18 sind derartig ausgebildet, daß die Platten 14 und 16, auch Schenkel genannt, aus dieser Anlieferungslage nahezu senkrecht zur Montageplatte 12, auch als Rückwand bezeichnet, gebogen werden können. In diesen sogenannten Einbauzustand (Figur 3) stützt sich der Schenkel 14 bzw. 16 jeweils an der Stirnseite 20 bzw. 22 der Rückwand 12 ab. Die Schenkel 14 und 16 sind jeweils mit Führungen 24 versehen, die die weiteren elektronischen Baugruppen 2 und 4 führen sollen. Diese Führungen 24 können mit Federelementen versehen werden, damit die Flachbaugruppen 2 und 4 (Figur 5) in den Führungen 24 fixiert sind. Außerdem sind die Schenkel 14 und 16 mit Lüftungslöchern versehen, wobei sich die Anordnung und die geometrischen Abmessungen dieser Lüftungslöcher nach den Entlüftungslöchern der Elektronikbox 26 richten.

Die Montageplatte 12 weist auf der Seite 6 Verriegelungshaken 28, Tragarme 30, einen Halterarm 32 und Ausnehmungen 34 auf. Mittels der Verriegelungshaken 28, der Tragarme 30 und des Halterarms 32 werden eine zweiteilige Rückplatte 36, auch Busleiterplatte genannt, befestigt und justiert. Wie der Figur 3 zu entnehmen ist, besteht diese Busleiterplatte 36 aus einer Leiterplatte, insbesondere einer Mehrschichtleiterplatte, und mehreren Federleisten 38. Die Leiterplatte enthält alle notwendigen elektrischen Verbindungen der Kontaktstifte der vorhandenen Federleisten 38. Der obere Teil der zweiteiligen Rückplatte 36 stützt sich auf den Tragarme 30 ab und wird mittels der Verriegelungshaken 28 befestigt. Der untere Teil der zweiteiligen Rückplatte 36 wird vom Halterarm 32 und einem Verriegelungshaken 28 gehalten. Die Rückwand 12 der mehrteiligen Aufnahmeteils 8 kann auch mit einer einteiligen Rückplatte 36 versehen sein, die beispielsweise Federleisten 38 für mehr als zwei weitere Baugruppen 2 und 4 aufweist. Bei einer einteiligen Busleiterplatte 36 werden die Tragarme 30 und der Halterarm 32 nicht mehr benötigt.

Die Busleiterplatte 36 weist auf ihrer Lötseite die Enden der Kontaktstifte der Federleisten 38 auf, wodurch keine plane Oberfläche auf der Lötseite der Busleiterplatte 36 vorhanden ist. Damit eine derartige Busleiterplatte 36 an der Montageplatte 12 befestigt werden kann, müssen entweder die Verriegelungshaken 28, die Tragarme 30 und der Halterarm 32 um die aus der Busleiterplatte 36 herausragenden Kontaktstiftlängen verlängert werden oder die Montageplatte 12 weist, wie in Figur 1 dargestellt, Ausnehmungen 34 auf, die die aus der Busleiterplatte 36 herausragenden Kontaktstiftlängen aufnehmen. Deshalb sind die Ausnehmungen 34 jeweils im Schatten einer Federleiste 38 der Busleiterplatte 36 angeordnet. Außerdem kann durch diese Ausgestaltung die Rückplatte 36 mit minimalem Abstand zur Rückwand 12 montiert werden, so daß die weiteren Baugruppen 2 und 4 und eine bereits vorhandene Baugruppe 40 in der Elektronikbox 26 frontseitig eine Ebene bilden.

Als Verriegelungshaken 28 sind Doppelrasthaken vorgesehen, die beabstandet zueinander angeordnet sind. Dieser Abstand zwischen den benachbarten Rasthaken nimmt zum Haken am freien Ende hin zu, und die Haken sind jeweils auf sich abgewandten Seiten der Rasthaken angebracht. Mit einem solchen Verriegelungshaken 28 erhält man eine stabile Verriegelung der Rückplatte 36 mit der Rückwand 12, die ebenfalls leicht hergestellt werden kann. Durch die Verwendung von mehreren Verriegelungshaken 28 für die Befestigung der Rückplatte 36 mit der Rückwand 12 des mehrteiligen Aufnahmeteils 8 übernehmen diese Verriegelungshaken 28 ebenfalls die Aufgabe der Justierung.

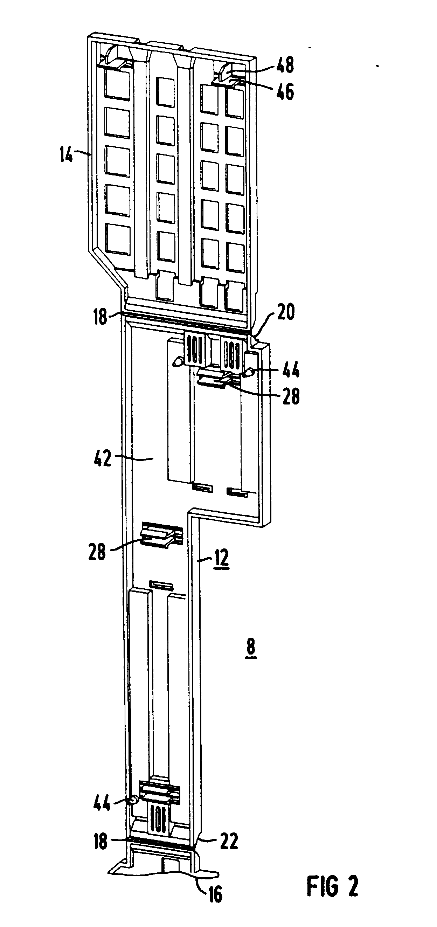

Die Figur 2 zeigt die Rückansicht auf das mehrteilige Aufnahmeteil 8. Dieser Ansicht ist zu entnehmen, daß die den Baugruppen 2 und 4 abgewandte Seite 42 der Rückwand 12 ebenfalls Verriegelungshaken 28 und Positionierstifte 44 aufweist. Mittels dieser Verriegelungshaken 28 und Positionierstifte 44 wird das mehrteilige Aufnahmeteil 8 im Gehäuse 26 fixiert und in der Rückwand des Gehäuses 26 verriegelt. Auch die Rückseiten der Schenkel 14 und 16 weisen jeweils Rasthaken 46 und Positionierstege 48 auf, wobei bei dieser Darstellung der Schenkel 16 zum größten Teil weggeschnitten ist. Mittels dieser Rasthaken 46 und Positionierstege 48 werden die Schenkel 14 und 16 jeweils im Deckel bzw. Boden der Elektronikbox 26 fixiert und verriegelt.

Den Figuren 1 und 2 ist ebenfalls zu entnehmen, daß das mehrteilige Aufnahmeteil 8 einstückig als Kunststoffspritzteil ausgebildet ist. Dadurch läßt sich dieses Aufnahmeteil 8 preiswert und in Serie fertigen und weist eine ausreichende Steifigkeit auf, so daß eine einwandfreie Montage in der Elektronikbox 26 und ein einwandfreier Gebrauch dieser Einrichtung 10 zur Aufnahme weiterer Optionsbaugruppen 2 und 4 gewährleistet sind.

Wie bereits erwähnt, zeigt die Figur 3 die Einrichtung 10 zur Aufnahme weiterer Baugruppen 2 und 4, die wegen der Übersichtlichkeit hier nicht dargestellt sind, im Einbauzustand. Dieser Einbauzustand der Einrichtung 10 ist dadurch gekennzeichnet, daß die Rückplatte 36 an der Rückwand 12 des mehrteiligen Aufnahmeteils 8 befestigt ist und daß die beiden stirnseitig schwenkbar angebrachten Schenkel 14 und 16 mit der Rückwand 12 annähernd einen rechten Winkel einschließen.

Diese Ausführungsform des mehrteiligen Aufnahmeteils 8 unterscheidet sich von der in der Figur 1 dargestellten Ausführungsform dadurch, daß die stirnseitig angebrachten Schenkel 14 und 16 hier mit Führungen 24 versehen sind, die jeweils auf eine den Baugruppen 2 und 4 zugewandten Seite 50 angebracht sind. Außerdem sind die Führungen 24 jeweils mit Federelementen 52 ausgestattet. Diese Federelemente 52 sind Bestandteil einer jeden Führung 24, die ihrerseits Bestandteil jeweils eines Schenkels 14 bzw. 16 ist. Diese Federelemente 52 fixieren die jeweilige Baugruppe 2 bzw. 4 in der Führung und gleichen Dickentoleranzen der Baugruppe 2 bzw. 4 und/oder Fertigungstoleranzen des Spritzgußteils 8 aus.

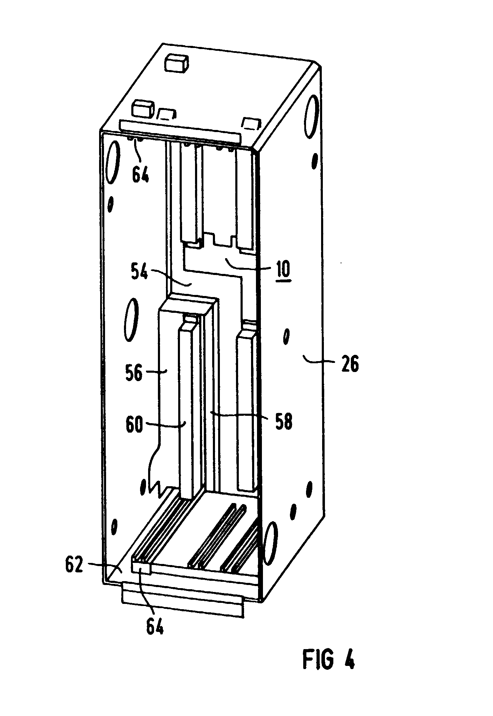

In der Figur 4 ist eine Elektronikbox 26 ohne Standardbaugruppe 40 und ohne weitere Baugruppen 2 und 4 dargestellt, in der die erfindungsgemäße Einrichtung 10 zur Aufnahme weiterer elektronischer Baugruppen 2 und 4 gesteckt und verriegelt ist. Für dieses Gehäuse 26 ist ein Blechformteil vorgesehen, wobei durch Kanten dieses Blechformteils längs vorgegebener Kantlinien die Raumform des Gehäuses 26 entsteht. Mittels dieses Blechformteils erhält man ein einteiliges, steifes und preiswertes Gehäuse 26. Das Gehäuse 26 weist an seiner Rückwand 54 eine Öffnung 56 auf, die dadurch entstanden ist, daß ein Teil des Rückwandbleches senkrecht nach innen gebogen ist, wodurch dieser Teil als Halteblech 58 für eine mehrpolige Federleiste 60 dient. Der Boden 62 und der Deckel dieser Elektronikbox 26 ist jeweils mit einer Führung 64 versehen, die so angebracht ist, daß eine Messerleiste 66 einer Standardbaugruppe 40 beim Einschieben dieser Standardbaugruppe 40 in die Federleiste 60 greift.

Anhand der Figur 5 soll der Montagevorgang der erfindungsgemäßen Einrichtung 10 zur Aufnahme weiterer Baugruppen 2 und 4 erläutert werden:

Eine vorhandene Elektronikbox 26, die bereits eine Standardbaugruppe 40 enthält, soll um zwei weitere Flachbaugruppen 2 und 4 nachträglich aufgerüstet werden. Die Elektronikbox 26 unterscheidet sich von der Ausführungsform des Gehäuses 26 gemäß Figur 4 dadurch, daß auf die Seitenwand links verzichtet wurde, wodurch sich das Gehäuse 26 weiter vereinfacht. Als Standardbaugruppe 40 bei Stromrichtergeräten dient die Regelungs- und Steuerungsbaugruppe, die mit einer Steuerklemmleiste 66 und einer Schnittstellenklemmleiste 68 versehen ist. In der hier dargestellten eingeschobenen Position der Standardbaugruppe 40 steht die Steuerklemmleiste 66 mit der Federleiste 60 am Halteblech 58 des Gehäuses 26 in Kontakt. Die Schnittstellenklemmleiste 68 steht in der Standardausführung mit keiner Federleiste in Kontakt.

Soll nun diese Elektronikbox 26 hochgerüstet werden, so muß zunächst die Standardbaugruppe 40 aus diesem Gehäuse 26 herausgezogen werden, damit die erfindungsgemäße Einrichtung 10 im Einbauzustand in das Gehäuse 26 eingeführt werden kann. Beim Einführen dieser Einrichtung 10 in die Elektronikbox 26 wird die Einrichtung 10 von der Gehäuseseitenwand und/oder von den beiden vorhandenen Führungen 64 geführt. Wenn der Endanschlag, die Gehäuserückwand, erreicht ist, schnappen die Verriegelungshaken 28 an den Schenkeln 14 und 16 und der abgewandten Seite 42 der Montageplatte 12 in korrespondierende Durchbrüche und Aufnahmen des Gehäuses 26 ein und befestigen somit die Einrichtung 10 zur Aufnahme weiterer Flachbaugruppen 2 und 4 in diesem Gehäuse 26. Die Verriegelungshaken 28 der Einrichtung 10 sind hier nicht dargestellt. Anschließend kann die ursprüngliche Standardbaugruppe, wie gewohnt, in ihren Steckplatz eingeschoben und befestigt werden. Durch die an der Montageplatte 12 befestigten Busleiterplatte 36 greift die Schnittstellenklemmleiste 68 nun in eine Federleiste 38 der Busleiterplatte 36. Somit ist das Bussystem der Standardbaugruppe 40 mittels der Schnittstellenklemmleiste 68 mit der Busleiterplatte 36 der Einrichtung 10 verbunden, in deren Steckplätze nun die weiteren Flachbaugruppen 2 und 4, beispielsweise eine Technologiebaugruppe und eine Schnittstellenbaugruppe, gesteckt werden, die in der gesteckten Position mit dem Bussystem der Standardbaugruppe 40 elektrisch leitend verbunden sind.

Bei der Montage der Einrichtung 10 zur Aufnahme weiterer elektronischer Baugruppen 2 und 4 wird kein Werkzeug benötigt. Außerdem werden keine zusätzlichen Verbindungselemente benötigt.

Mit dieser erfindungsgemäßen Einrichtung 10 erhält man nun die Möglichkeit, einerseits die Elektronikbox 26 besonders einfach aufbauen zu können, und andererseits eine derartig einfache Elektronikbox 26 mit weiteren Baugruppen 2 und 4 aufrüsten zu können, die kostengünstig, einfach und ohne Werkzeug schnell vor Ort eingebaut werden kann.

## Patentansprüche

1. Einrichtung (10) für eine mit wenigstens einer elektronischen Baugruppe (40) versehenen Elektronikbox (26) zur Aufnahme weiterer elektronischer Baugruppen (2,4), die jeweils mit der bereits vorhandenen Baugruppe (40) elektrisch leitend verbindbar sind, wobei diese Einrichtung (10) ein mehrteiliges Aufnahmeteil (8) aufweist, das aus einer Montageplatte (12) mit stirnseitig schwenkbar angebrachten zur Führung der weiteren Baugruppen (2,4) vorgesehenen Platten (14,16) besteht, wobei die Montageplatte (12) auf der den Baugruppen (2,4) zugewandten und abgewandten Seite (6,42) jeweils Verriegelungshaken (28) aufweist, mit denen einerseits eine mit Federleisten (38) versehene Rückplatte (36) mit der Montageplatte (12) und andererseits diese Einrichtung (10) mit der Elektronikbox (26) lösbar verbunden sind.

2. Einrichtung (10) nach Anspruch 1, wobei der Verriegelungshaken (28) so ausgestaltet ist, daß sein Basisteil als Abstandshalter wirkt.

3. Einrichtung (10) nach Anspruch 1, wobei die Montageplatte (12) auf der den Baugruppen (2,4) abgewandten Seite (42) Positionierstifte (44) aufweist.

4. Einrichtung (10) nach Anspruch 1, wobei die Platten (14,16) des Aufnahmeteils (8) auf der den Baugruppen (2,4) abgewandten Seiten Positionierstege (48) aufweist.

5. Einrichtung (10) nach Anspruch 1, wobei die Montageplatte (12) im Schatten der Federleisten (38) der Rückplatte (36) jeweils mit einer Ausnehmung (34) versehen ist.

6. Einrichtung (10) nach Anspruch 1, wobei als schwenkbare Verbindung ein Filmscharnier (18) vorgesehen ist.

7. Einrichtung (10) nach Anspruch 1, wobei die Montageplatte (12) auf der den Baugruppen (2,4) zugewandten Seite (6) mit wenigstens einem Tragarm (30) für die Rückplatte (36) versehen ist.

8. Einrichtung (10) nach Anspruch 1, wobei die Montageplatte (12) auf der den Baugruppen (2,4) zugewandten Seite (6) mit wenigstens einem Haltearm (32) versehen ist.

9. Einrichtung (10) nach Anspruch 1, wobei die schwenkbaren Platten (14,16) jeweils auf der den Baugruppen (2,4) abgewandten Seite mit Rasthaken (46) versehen sind.

10. Einrichtung (10) nach Anspruch 1, wobei die Rückplatte (36) mehrteilig ausgebildet ist.

11. Einrichtung (10) nach Anspruch 1, wobei das mehrteilige Aufnahmeteil (8) einstückig ausgebildet ist.

12. Einrichtung (10) nach Anspruch 1 und 11, wobei als mehrteiliges Aufnahmeteil (8) ein Kunststoffspritzteil vorgesehen ist.

## Claims

1. A fitting (10) for an electronics enclosure (26) fitted with at least one electronics card (40), for reception of further electronics cards (2, 4) that can each be electrically connected to the card (40) already present, this fitting comprising a multipart receiving element (8) comprising a mounting plate (12) including end plates (14, 16) for guidance of the further cards (2, 4) provided swingably on its ends, the mounting plate (12) having locking hooks (28) on each of its sides (6, 42) facing towards and away from the cards (2, 4), with which on the one hand a back plane (36) provided with edge connectors (38) can be detachably connected to the mounting plate (12) and on the other hand said fitting (10) can be detachably connected to the electronics enclosure (26).

2. A fitting (10) according to claim 1, in which locking hooks (28) are formed so that their base part acts as a spacer.

3. A fitting (10) according to claim 1, in which the mounting plate (12) includes positioning pins (44) on the side (42) facing away from the cards (2, 4).

4. A fitting (10) according to claim 1, in which the end plates (14, 16) of the receiving element (8) have positioning webs (48) on the sides facing away from the cards (2, 4).

5. A fitting (10) according to claim 1, in which the mounting plate (12) is provided with at least one recess (34) in the shadow of the edge connectors (38) of the back plane (36).

6. A fitting (10) according to claim 1, in which a film hinge (18) is provided as the swingable connection.

7. A fitting (10) according to claim 1, in which the mounting plate (12) includes at least one supporting arm (30) for the back plane (36) on the side (6) facing towards the cards (2, 4).

8. A fitting (10) according to claim 1, in which the mounting plate (12) includes at least one holding arm (32) on the side (6) facing towards the cards (2, 4).

9. A fitting (10) according to claim 1, in which each of the swingable plates (14, 16) is provided with detent hooks (46) on its side facing away from the cards (2, 4).

10. A fitting (10) according to claim 1, in which the back plane (36) is in multipart form.

11. A fitting (10) according to claim 1, in which the multipart receiving element (8) is formed in one piece.

12. A fitting (10) according to claim 1 and claim 11, in which said multipart receiving element (8) is a plastics injection moulding.

## Revendications

1. Dispositif (10) pour une boîte électronique (26) munie d'au moins un module électronique (40) et destinée à la réception d'autres modules (2, 4) électroniques, qui peuvent être reliés chacun de manière à conduire l'électricité au module (40) déjà présent, ce dispositif (10) comportant une pièce (8) de réception en plusieurs parties, qui est constituée d'une plaque (12) de montage comportant des plaques (14, 16) disposées basculantes frontalement et prévues pour le guidage des autres modules (2, 4), la plaque (12) de montage comportant, des côtés (6, 42) tournés et éloignés des modules (2, 4), des crochets (28) de verrouillage, par lesquels d'une part une plaque (36) arrière munie de connecteurs (38) à ressort est reliée de manière amovible à la plaque (12) de montage et d'autre part ce dispositif (10) est relié de manière amovible à la boîte électronique (26).

2. Dispositif (10) suivant la revendication 1, dans lequel le crochet (28) de verrouillage a une forme telle que sa partie de base agit comme entretoise.

3. Dispositif (10) suivant la revendication 1, dans lequel la plaque (12) de montage comporte, du côté (42) éloigné des modules (2, 4), des broches (44) de positionnement.

4. Dispositif (10) suivant la revendication 1, dans lequel les plaques (14, 16) de la pièce (8) de réception comportent, des côtés éloignés des modules (2, 4), des barrettes (48) de positionnement.

5. Dispositif (10) suivant la revendication 1, dans lequel la plaque (12) de montage comporte, dans l'ombre des connecteurs (38) à ressort de la plaque arrière (36), un évidement (34).

6. Dispositif (10) suivant la revendication 1, dans lequel il est prévu comme liaison basculante une charnière-film (18).

7. Dispositif (10) suivant la revendication 1, dans lequel la plaque (12) de montage est munie, du côté (6) tourné vers les modules (2, 4), d'au moins un bras (30) de support pour la plaque arrière (36).

8. Dispositif (10) suivant la revendication 1, dans lequel la plaque (12) de montage est munie, du côté (6) tourné vers les modules (2, 4), d'au moins un bras (32) de maintien.

9. Dispositif (10) suivant la revendication 1, dans lequel les plaques (14, 16) basculantes sont munies chacune, du côté éloigné des modules (2, 4), de crochets (46) d'encliquetage.

10. Dispositif (10) suivant la revendication 1, dans lequel la plaque arrière (36) est en plusieurs parties.

11. Dispositif (10) suivant la revendication 1, dans lequel la partie (8) de réception en plusieurs parties est d'une seule pièce.

12. Dispositif (10) suivant la revendication 1 et 11, dans lequel il est prévu comme partie (8) de réception en plusieurs parties une pièce moulée par injection de matière plastique.
